Europäisches Patentamt

European Patent Office

Office européen des brevets

(11) Numéro de publication: **0 280 363 B1**

## FASCICULE DE BREVET EUROPEEN

(45) Date de publication de fascicule du brevet: **21.10.92** (51) Int. Cl.⁵: **G11C 11/44**

(21) Numéro de dépôt: **88200281.9**

(22) Date de dépôt: **16.02.88**

(54) **Circuit de stockage d'informations à faible temps d'accès.**

(30) Priorité: **20.02.87 FR 8702232**

(43) Date de publication de la demande:
**31.08.88 Bulletin 88/35**

(45) Mention de la délivrance du brevet:
**21.10.92 Bulletin 92/43**

(84) Etats contractants désignés:
**DE FR GB IT NL**

(56) Documents cités:
**EP-A- 0 056 904**
**EP-A- 0 185 104**

**PATENT ABSTRACTS OF JAPAN, vol. 7, no 214, (E-199)[1359], 21 septembre 1983; & JP-A-58 107 679**

**IBM TECHNICAL DISCLOSURE BULLETIN, vol. 25, no. 9, février 1983, pages 4597-4598, New York, US; R.E. DRAKE et al.: "Ouiteron process steps"**

**PATENT ABSTRACTS OF JAPAN, vol. 8, no. 221 (E-271)[1658], 9 octobre 1984; & JP-A-59 103 389**

(73) Titulaire: **LABORATOIRES D'ELECTRONIOUE PHILIPS**
**3, Avenue Descartes**
**F-94450 Limeil-Brévannes(FR)**
(84) Etats contractants désignés:
**FR**

(73) Titulaire: **N.V. Philips' Gloeilampenfabrieken**
**Groenewoudseweg 1**
**NL-5621 BA Eindhoven(NL)**
(84) Etats contractants désignés:
**DE GB IT NL**

(72) Inventeur: **Gabillard, Bertrand Société Civile S.P.I.D.**
**209, rue de l'Université**
**F-75007 Paris(FR)**
Inventeur: **Patillon, Jean-Noel Société Civile S.P.I.D.**
**209, rue de l'Université**
**F-75007 Paris(FR)**

(74) Mandataire: **Landousy, Christian et al**
**Société Civile S.P.I.D. 156, Boulevard Haussmann**
**F-75008 Paris(FR)**

## Description

L'invention concerne un circuit de stockage d' informations à faible temps d'accès intégré monolithiquement sur un substrat.

Un circuit de stockage d'informations à faible temps d'accès est décrit dans "IEEE Transactions on electron devices" Vol.ED-33, N°1 de janvier 1986, pages 104 à 110. Un tel circuit rapide est conçu suivant une matrice de points mémoire reliés entre eux par des lignes d'interconnexion. Cette matrice de points mémoire est séparée en deux pour diviser par deux la longueur de ces lignes d'accès aux point mémoire et réduire ainsi d'environ un facteur 4 le temps de propagation du signal. En effet à une ligne d'accès est associée une résistance R et une capacité C toutes deux dépendantes de la longueur de la ligne, la constante de temps RC est donc pratiquement fonction du carré de la longueur, ainsi en divisant par 2 la longueur de la ligne, le temps de propagation est divisé par 4. Il serait possible de cette manière de réduire encore le temps de propagation de quelques ordres de grandeur en partageant par exemple la matrice de points mémoire en quatre parties, mais cette méthode ne peut plus être satisfaisante et ne suffit plus lorsque les signaux d'information sont ultrarapides par exemple pour des applications concernant un super ordinateur fonctionnant à des vitesses de l'ordre de 100 à 1000 MIPS (Méga instructions par seconde). Un inconvénient majeur à utiliser dans ce cas une telle méthode est que le temps de propagation n'étant plus négligeable relativement au front de montée des signaux, ces derniers subissent un retard, sont déformés et ne sont pas reproduits à l'identique en sortie de circuit.

Il est par ailleurs connu de l'état de la technique, par la demande de brevet européen N° 056904, d'apporter une amélioration à la limitation de la mobilité des électrons ou des trous dans le silicium. A cet effet, il est connu par le document cité, d'utiliser les électrons libres accumulés au voisinage d'une hétérojonction formée à l'interface de deux couches de matériaux semiconducteurs différents ayant des affinités électroniques différentes. Un tel groupe d'électrons libres (gaz d'électrons quasi-bidimensionnel) existe dans une région ayant une épaisseur extrêmement petite, par exemple 1 nm, et subit dans une plus faible mesure l'effet de la diffusion d'impuretés ionisées. Ceci provoque une augmentation considérable de la mobilité électronique, particulièrement aux températures cryogéniques, auxquelles l'effet de dispersion d'impuretés ionisées est le facteur dominant de la limitation de la mobilité électronique. Parmi les matériaux semiconducteurs sélectionnés pour montrer une différence substantielle d'affinité électronique, le document cité enseigne que, par exemple, des couches de GaAs et AlGaAs peuvent être utilisées. Cette idée est mise en application pour réaliser un transistor à haute mobilité électronique (HEMT).

La présente invention propose une solution efficace pour éviter l'inconvénient lié au premier document cité.

Pour cela, le circuit de stockage d'informations à faible temps d'accès du genre mentionné dans le préambule est remarquable en ce qu'il est réalisé en matériau semiconducteur présentant un gaz de porteurs électroniques bidimensionnel, matériau semiconducteur créé à partir de l'empilement de couches d'un matériau à faible bande interdite et d'un matériau à plus grande bande interdite, ou l'inverse, le gaz bidimensionnel étant situé à l'interface de ces deux couches, en ce qu'il comprend des moyens pour appliquer à ce matériau un champ magnétique B et une température appropriés pour rendre ledit matériau semiconducteur supraconducteur, et en ce qu'il comprend au moins une spire $S_1$ formée dans ledit matériau semiconducteur, un premier contact $C_1$ pour relier le centre de la spire à un potentiel de référence, par exemple la masse, un second contact $C_2$ localisé contre et à l'extérieur de la spire pour injecter dans la spire $S_1$ un courant portant des informations, ledit matériau semiconducteur à l'état supraconducteur permettant l'extrême réduction du temps d'accès et la conservation quasi-illimitée des informations stockées dans la spire $S_1$.

Ainsi, dans des conditons de température et de champ magnétique prédéterminées le matériau dudit circuit est rendu supraconducteur, la conduction étant quasi-idéale, les signaux peuvent se propager pratiquement à la vitesse de la lumière dans le milieu considéré. De ce fait, les retards et déformations des signaux rapides constatés lors de la propagation de ceux-ci dans des circuits traditionnels sont quasiment supprimés et les signaux à la sortie de circuits fonctionnant selon l'idée de l'invention sont parfaitement restitués, de même les informations stockées sont idéalement conservées et entretenues comme cela sera montré dans la suite du présent mémoire.

Le circuit de stockage d'informations est alors réalisé à partir d'une matrice de points mémoire, encore appelés cellules mémoire pour, par exemple, constituer une mémoire RAM statique monolithiquement intégrée.

Selon une application préférée mais non limitative, pour former une cellule mémoire le circuit de stockage d'informations comprend en outre au moins un transistor $T_1$ pour amener le courant portant les informations sur ledit second contact $C_2$ extérieur à la spire.

La spire est rendue semicondcutrice par la présence du gaz bidimensionnel d'électrons confiné entre les deux couches.

A basse température (par exemple 4,2° K) et pour certaines valeurs élevées du champ magnétique (par exemple 7 Teslas) appliqué perpendiculairement à la spire, le phénomène de supraconductivité est observé dans la couche semiconductrice.

Dans un mode de réalisation préférentielle, ce circuit comprend en outre, dans la cellule mémoire, une grille déposée sur la spire pour, dans un cas désiré, autoriser la perturbation du gaz bidimensionnel d'électrons et ainsi faire disparaître momentanément les propriétés supraconductrices du matériau semiconducteur, et permettre la lecture par le moyen du premier transistor $T_1$ des informations stockées dans la spire.

En effet, l'idée de l'invention est d'utiliser l'effet Hall quantifié pour soit, injecter à partir de deux contacts un courant dans la spire, ou bien recueillir (ou non) entre ces deux contacts la tension de Hall dans le cas où il circule (ou non ) un courant dans la spire, le courant étant l'élément d'information et la spire l'élément de stockage. Un tel effet est clairement décrit dans un certain nombre d'ouvrages ou de publications parmi lesquelles "Surface Science 142" (ELSEVIER, 1984) par H.L. Störmer, Novel Physics in two dimensions, pages 130 à 146, en particulier paragraphe 3-2 page 136.

D'autre part, de préférence, ce circuit comprend en outre, dans la cellule mémoire, un second transistor $T_2$ pour amener un courant sur la grille GR par le moyen d'un autre contact $C_2$, localisé contre et à l'extérieur de la spire et reliant le second transistor $T_2$ à la grille GR.

La description suivante en regard des dessins annexés, le tout donné à titre d'exemple, fera bien comprendre comment l'invention peut être réalisée.

La figure 1 représente une structure possible d'une cellule mémoire vue suivant une coupe transversale.

La figure 2 représente un schéma électrique d'une cellule mémoire.

La figure 3 représente une réalisation technologique d'une cellule mémoire

La figure 4 représente les signaux de commande de la cellule mémoire en fonction du temps.

La figure 5 représente une disposition matricielle d'un ensemble de cellules mémoire.

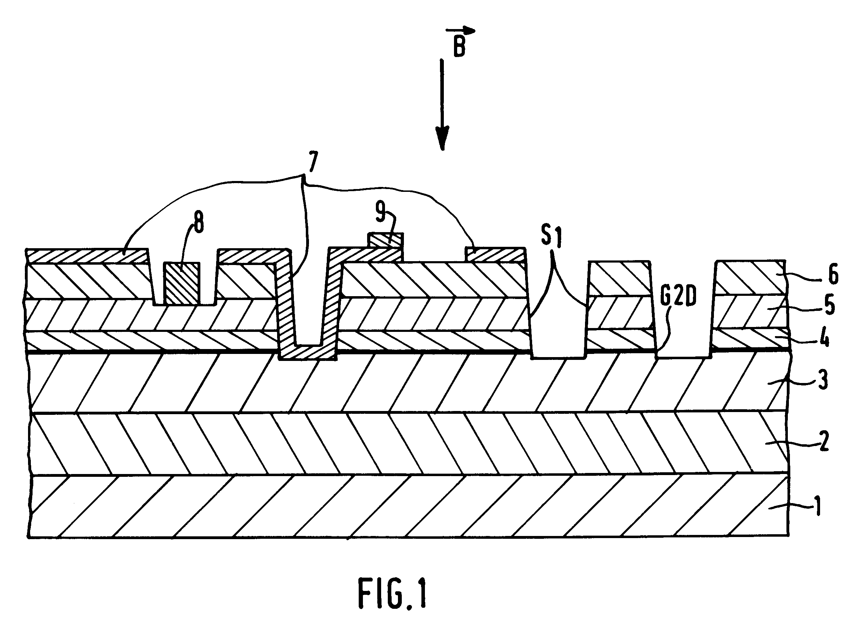

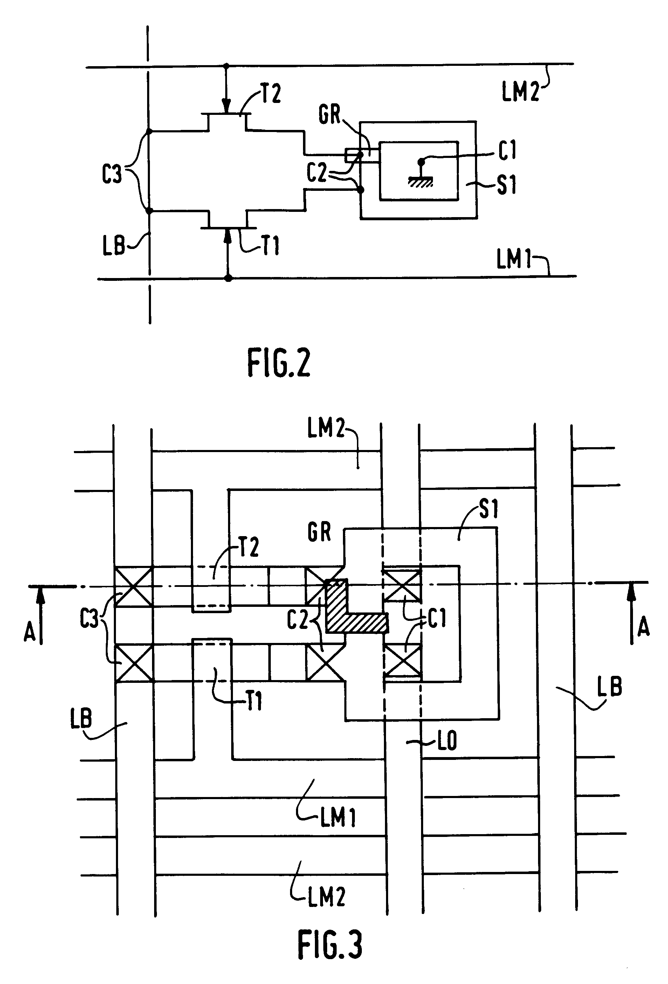

Sur la figure 1 est représentée une des structures épitaxiales possibles d'une cellule mémoire selon une coupe transversale, plus particulièrement selon la coupe AA de la figure 3. Conformément à l'idée de l'invention le matériau nécessaire à la mise en oeuvre du circuit doit présenter un gaz de porteurs électroniques (électrons ou trous) à deux dimensions ; il est réalisé à partir de l'empilement de couches d'un matériau à faible bande interdite et d'un matériau à plus grande bande interdite (ou réciproquement). Le gaz bidimensionnel est situé à l'interface de ces deux couches, la présence de ce gaz rendant le matériau semi-conducteur. Une grande variété de matériaux et notamment les matériaux III-V (convenant particulièrement à cette application) incluant leurs alliages ternaires et quaternaires autorise à un grand nombre de combinaisons desdits matériaux. Selon une réalisation préférée du circuit selon l'invention le choix s'est porté sur une combinaison du type AlGaAs/GaAs. De toute évidence, ce choix n'est pas limitatif, d'autres combinaisons auraient parfaitement pu convenir.

Une fois le matériau choisi, la structure épitaxiale est obtenue sur une couche 1 de GaAs semi-isolant dopé chrome, elle est constituée d'une couche 2 de AlGaAs non dopé d'épaisseur L2 (0,5μm≤L2≤1μm), d'une couche 3 de GaAs non dopé d'épaisseur L3 (0,5μm≤L3≤1μm), d'une couche fine 4 de AlGaAs non dopé d'épaisseur L4 (20Å≤L4≤100Å), d'une couche 5 de AlGaAs dopé silicium d'épaisseur L5 (50Å≤L5≤500Å, $N_{D5} \approx 10^{18} cm^{-3}$) et finalement d'une couche 6 de GaAs dopé silicium d'épaisseur L6 (50Å≤L6≤500Å, $N_{D6} \approx 10^{18} cm^{-3}$). Le gaz bidimensionnel référencé G2D est localisé à l'hétérojonction des couches 3 et 4. Les épaisseurs des couches 4 et 5 ainsi que le dopage de la couche 5 sont choisis de sorte que la densité d'électrons du gaz à deux dimensions $n_{2D}$ soit de l'ordre de $3.10^{11} cm^{-2}$.

Cette densité d'électrons correspond à l'obtention du plateau de Hall correspondant au deuxième sous-niveau de Landau du gaz à deux dimensions rempli pour un champ magnétique $\vec{B}$ dont l'induction est inférieure à 7 Teslas (le champ magnétique étant appliqué perpendiculairement au plan du circuit, voir figure 1). Il est entendu que la présente invention peut s'étendre à des concentrations de gaz plus élevées ainsi qu'à des plateaux de Hall obtenus à des champs plus intenses.

D'autre part, afin d'obtenir l'effet supraconducteur désiré en combinaison avec les autres caractéristiques la température est maintenue basse. Dans l'exemple de réalisation choisi, elle était de l'ordre de quelques ° K (4,2° K).

La couche 7 représente une métallisation qui est par exemple de l'AuGeNi, la couche 7 recouvre une partie de la spire (référencée S1). La spire est isolée du reste de la couche bidimensionnelle par décapage chimique des couches 4, 5, 6. La présente invention peut être étendue à d'autres types d'isolation, par exemple à une isolation obtenue par implantation de bore.

Les transistors de sélection à effet de champ sont du type HEMT. Ils sont séparés de la spire soit par décapage chimique, soit par implantation. Les transistors HEMT sont obtenus sur les mêmes couches épitaxiales en déposant une métallisation Schottky 8 sur la couche 5 pour la grille, la métallisation 7 fournissant d'autre part les deux contacts ohmiques sur la couche 6 relatifs au drain et à la source.

Selon une des caractéristiques de l'invention pour chacune des cellules mémoire un des deux contacts ohmiques situés contre et à l'extérieur de la spire est de plus relié à la grille déposée sur la spire pour, dans un cas désiré, autoriser la perturbation du gaz bidimensionnel d'électrons et ainsi faire disparaître momentanément les propriétés supraconductrices du matériau semi-conducteur. En effet, la grille 9 est déposée sur la métallisation 7, reliant la source du transistor T2 (voir figure 3) au contact C2 (figure 3) situé contre et à l'extérieur de la spire S1, et sur la spire S1. La grille 9 est ici représentée selon la coupe AA de la figure 3, cependant elle apparaît dans son intégralité sur ladite figure 3. La grille 9 est par exemple en TiPt.

Sur la figure 2 est représenté un schéma électrique d'une cellule mémoire. Conformément à l'invention la cellule mémoire est constituée d'une spire semi-conductrice S1 dont le centre est relié à la masse par l'intermédiaire de contacts ohmiques C1. Deux contacts C2 sont localisés contre la spire mais à l'extérieur de celle-ci. La cellule mémoire comprend, en outre, deux transistors de sélection T1 et T2 commandés respectivement par les signaux d'adresse portés par des lignes de mot LM1 et LM2. Les sources de ces deux transistors T1, T2 sont reliées aux contacts C2 alors que les drains de T1 et T2 sont reliés à une ligne de bit LB par l'intermédiaire de contacts C3. Enfin une grille GR est placée sur la spire S1, elle est également reliée à la source du transistor T2 par le contact C2 sur lequel elle est également déposée.

Sur la figure 3 est proposée une représentation graphique détaillée d'une réalisation technologique d'une cellule mémoire. Pour la réalisation d'une cellule mémoire une surface sensiblement carrée d'un peu plus de 100 $\mu$m x $\mu$m est nécessaire.

Les éléments communs des figures 2 et 3 sont identiquement référencés.

La fonction mémoire est réalisée par la présence ou l'absence d'un courant dans la spire S1 :
- l'état "1" correspond à l'existence d'un courant
- l'état "0" correspond à l'absence d'un courant

La création d'un courant se fait de la façon suivante. Le champ magnétique $\vec{B}$ étant indépendant du temps, une tension positive VB de 1 volt est appliquée sur la ligne de bit LB, en appliquant de même une tension positive VM1 de 1 volt sur la ligne de mot LM1 le transistor T1 est rendu conducteur. Dans ce cas un courant I va être créé entre la ligne de bit LB et le contact ohmique C1 relié à la ligne de masse L0, contact ohmique C1 situé vis à vis du contact ohmique C2 lui-même en contact avec la source du transistor T1. Comme la spire est supraconductrice en présence du champ magnétique et de la basse température, le courant I va être dérivé dans la spire et y être piégé. Ainsi piégé dans la spire, le courant I est maintenu même lorsque les tensions VB et VM1 deviennent nulles. C'est l'effet supraconducteur qui permet l'existence continuelle du courant I.

L'annulation du courant I est réalisée de la façon suivante. Une tension positive VGR de 1 volt est appliquée sur la grille GR par l'intermédiaire du contact C2 relié à la source du transistor T2 rendu dans ce cas conducteur. Cette tension positive perturbe le gaz bidimensionnel d'électrons et fait disparaître momentanément les propriétés supraconductrices de ce gaz, entraînant de la sorte la disparition du courant supraconducteur I.

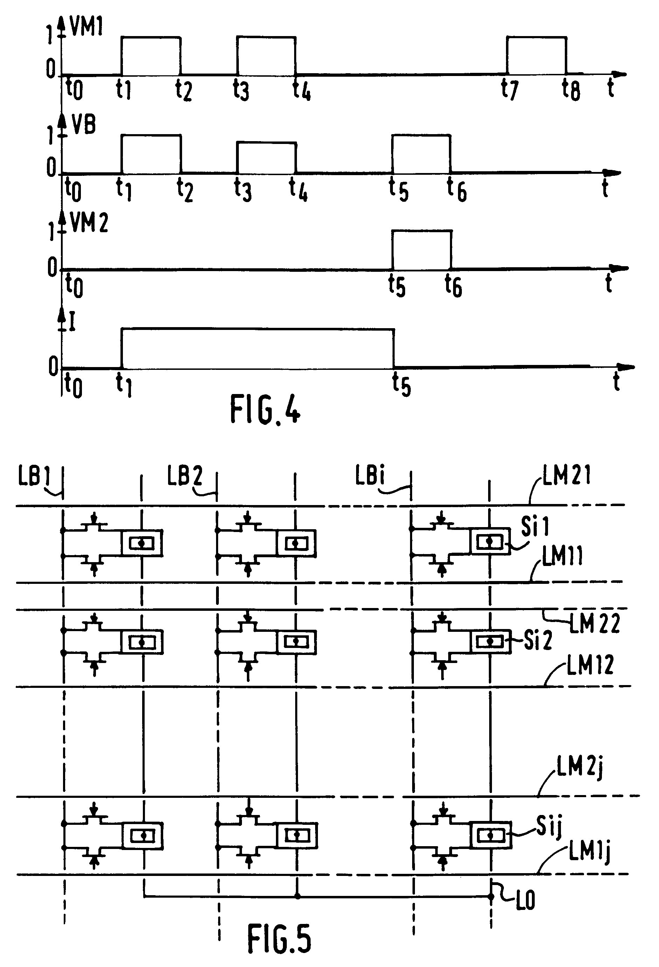

Sur la figure 4 sont représentés les signaux de commande de la cellule mémoire en fonction du temps.

Le chronogramme représente un cycle d'écriture d'un état "1", suivi d'un cycle de lecture de cet état "1", lui-même suivi d'un cycle d'écriture d'un état "0" et enfin de la lecture d'un état "0".

Au temps t0, la cellule n'est pas adressée et son état est "0" car le courant I est nul.

Au temps t1, la ligne de mot LM1 est forcée à un potentiel VM1 = 1V. La ligne de bit LB est forcée à un potentiel VB = 1V. Le cycle d'écriture débute et un courant I apparaît et circule dans la spire.

Au temps t2, la ligne de mot LM1 est forcée à un potentiel VM1 = 0V. La ligne de bit LB est forcée à un potentiel VB = 0V. Le courant I continue de circuler dans la spire. Le cycle d'écriture est terminé.

Au temps t3, la ligne de mot LM1 est forcée à un potentiel VM1 = 1V. La ligne de bit LB est à un potentiel VB≈0,8V. Le cycle de lecture débute et la tension de Hall VB apparaît sur la ligne de bit LB. Le courant I continue de circuler dans la spire.

Au temps t4, la ligne de mot LM1 est forcée à un potentiel VM1 = 0V. La ligne de bit LB est à un potentiel VB qui décroît à 0V. Le cycle de lecture est terminé et la tension de Hall VB disparaît sur la ligne de bit LB. Le courant I continue de circuler dans la spire.

Au temps t5, la ligne de mot LM2 est forcée à un potentiel VM2 = 1V. La ligne de bit LB est forcée à un potentiel VB = 1V. Le cycle d'écriture débute et le courant I dans la spire devient nul, car le potentiel de la grille GR devient VGR = 1V ce qui perturbe le gaz bidimensionnel d'électrons et fait disparaître pendant ce temps les propriétés supraconductrices de ce gaz et donc fait disparaître I qui retrouvant un matériau résistif, s'élimine par effet Joule.

Au temps t6, la ligne de mot LM2 est forcée à un potentiel VM2 = 0V. La ligne de bit LB est forcée à un potentiel VB = 0V. Le cycle d'écriture est terminé et le courant I dans la spire est toujours nul.

Au temps t7, la ligne de mot LM1 est forcée à un potentiel VM1 = 1V. La ligne de bit LB est à un potentiel VB = 0V. Le cycle de lecture débute. La tension de Hall VB est nulle et le courant I est nul.

Au temps t8, la ligne de mot LM1 est forcée à un potentiel VM1 = 0V. La ligne de bit LB est toujours à un potentiel VB qui est nul. Le cycle de lecture est terminé et le courant I est toujours nul.

Sur la figure 5 est représentée une disposition matricielle d'un ensemble de cellules mémoire permettant la réalisation d'une mémoire RAM statique.

Les cellules mémoires Mij sont organisées sous la forme d'un réseau de cellules qui présente la structure d'une matrice. Chaque cellule (M11, M21,...Mi1,...,M12, M22,...,Mi2,...M1j, M2j,...,Mij,...) correspond à un chiffre binaire et est située au croisement de deux lignes, une ligne horizontale ou rangée (i), une ligne verticale ou colonne (j). Ainsi chaque cellule de la mémoire a une adresse unique et peut être sélectionnée en activant simultanément la rangée et la colonne appropriées.

Cette sélection est faite par l'intermédiaire de circuits décodeurs sur les entrées desquels sont appliquées les adresses de la mémoire codées en binaire et dont les sorties ou lignes de mot LM1j ou LM2j commandent l'accès des cellules mémoire.

Après sélection de la cellule mémoire, une donnée peut en être extraite, ou peut lui être transmise par une ligne de bit LBi, commune à toutes les cellules d'une même colonne de la mémoire.

Les contacts ohmiques centraux des spires Si1, Si2,...,Sij,...d'une même colonne sont reliés entre eux par une ligne de masse L0, isolée de chaque spire par un diélectrique. Le contact entre la ligne L0 et chaque contact ohmique central (C1, voir figure 2) de la spire est réalisé par un trou dans le diélectrique qui isole les lignes de mot LM1j, LM2j et les lignes de bit LBi et de masse L0.

Les lignes de mot LM1j sont utilisées en mode lecture des états "1" et "0" ou en mode écriture d'un état "1" (création du courant I).

Les lignes de mot LM2j sont uniquement utilisées en mode écriture d'un état "0" (annulation du courant I).

Les lignes de bit LBi sont utilisées en mode lecture ou écriture.

La sélection des lignes LM1j, LM2j, LBi est effectuée de façon classique à l'aide de circuits de décodage d'adresses.

Il va de soi que, d'une part, l'application de l'invention aux mémoires réalisées à l'aide de transistors à effet de champ intégrées sur un substrat de GaAs n'est pas limitative et d'autre part de nombreuses variantes sont possibles, en particulier relativement à la taille, aux caractéristiques et aux tensions des lignes de commande, sans pour autant sortir du cadre de la présente invention.

Cette invention trouve particulièrement et avantageusement bien sa place dans de nouvelles applications, notamment dans la mise en oeuvre d'un super ordinateur, où il est trouvé naturellement l'environnement (champ magnétique, basse température) nécessaire à l'obtention de l'effet supraconducteur.

## Revendications

1. Circuit de stockage d'informations à faible temps d'accès intégré monolithiquement sur un substrat (1), caractérisé en ce qu'il est réalisé en matériau semiconducteur présentant un gaz de porteurs électroniques bidimensionnel (G2 D), matériau semiconducteur créé à partir de l'empilement de couches (3,4) d'un matériau à faible bande interdite (3) et d'un matériau à plus grande bande interdite (4), ou l'inverse, le gaz bidimensionnel G2D étant situé à l'interface de ces deux couches (3,4), en ce qu'il comprend des moyens pour appliquer à ce matériau un champ magnétique B et une température appropriés pour rendre ledit matériau semiconducteur supraconducteur, et en ce qu'il comprend au moins une spire $S_1$ formée dans ledit matériau semiconducteur, un premier contact $C_1$ pour relier le centre de la spire à un potentiel de référence, par exemple la masse, un second contact $C_2$ localisé contre et à l'extérieur de la spire pour injecter dans la spire $S_1$ un courant portant des informations, ledit matériau semiconducteur à l'état supraconducteur permettant l'extrême réduction du temps d'accès et la conservation quasi-illimitée des informations stockées dans la spire $S_1$.

2. Circuit de stockage d'informations à faible temps d'accès selon la revendication 1, caractérisé en ce que pour former une cellule mémoire, il comprend en outre, au moins un transistor $T_1$ pour amener le courant portant les informations sur ledit second contact $C_2$ extérieur à la spire.

3. Circuit de stockage d'informations à faible temps d'accès selon la revendication 2, caractérisé en ce qu'il comprend en outre, dans la cellule mémoire, une grille GR déposée sur la spire pour, dans un cas désiré, autoriser la perturbation du gaz bidimensionnel d'électrons et ainsi faire disparaître momentanément les propriétés supraconductrices du matériau semiconducteur, et permettre la lecture par le moyen du premier transistor $T_1$ des informations stockées dans la spire.

**4.** Circuit selon la revendication 3, caractérisé en ce qu il comprend en outre, dans la cellule mémoire, un second transistor $T_2$ pour amener un courant sur la grille GR par le moyen d'un autre contact $C_2$, localisé contre et à l'extérieur de la spire et reliant le second transistor $T_2$ à la grille GR.

**5.** Circuit selon la revendication 4, caractérisé en ce qu'il comporte en outre en surface du matériau semiconducteur (3,4) des couches semiconductrices (5,6), pour la réalisation des premier et second contacts $C_1$ et $C_2$ sous forme de contacts ohmiques et pour la réalisation des premier et second transistors $T_1$ et $T_2$.

**6.** Circuit selon la revendication 5, caractérisé en ce que le substrat 1 est en GaAs semi-isolant, le matériau semiconducteur (3,4) avec un gaz bidimensionnel G2D est formé de l'empilement d'une couche (3) de GaAs non dopée et d'une couche (4) de GaAlAs non dopée, en ce que les couches supérieures (5,6) sont formées de l'empilement d'une couche (5) de AlGaAs de type de conductivité n, dopée par exemple au moyen de Si, et d'une couche (6) de GaAs de type de conductivité n dopée par exemple au moyen de Si, en ce que les transistor $T_1$ et $T_2$ sont du type HEMT, et en ce que dans la cellule mémoire les lignes de mots sont reliées respectivement aux grilles des transistor $T_1$ et $T_2$, transistors dont les drains sont par ailleurs reliés à une ligne de bit, et les sources chacune à un contact $C_2$ extérieur à la spire $S_1$.

**7.** Circuit selon l'une des revendications 4 à 7, caractérisé en ce qu'il comprend une multiplicité de telles cellules mémoires, organisées sous la forme d'un réseau de cellules qui présente la structure d'une matrice.

**Claims**

**1.** An information storage circuit with low access time integrated monolithically on a substrate (1), characterised in that it is realised in a semiconductor material having a two-dimensional electron carrier gas (G2D), which semiconductor material is formed through stacking of layers (3, 4) of a material having a narrow bandgap (3) and a material having a wider bandgap (4), or *vice versa,* the two-dimensional gas (G2D) being situated at the interface of these two layers (3, 4), and in that it comprises means for applying to this material a magnetic field B and a temperature which are suitable for rendering the said semiconductor material superconducting, and in that it comprises at least one loop $S_1$ formed in the said semiconductor material, a first contact $C_1$ for connecting the centre of the loop to a reference potential, for example earth, a second contact $C_2$ positioned against the outside of the loop for injecting into the loop $S_1$ an information-carrying current, while the semiconductor material in the superconducting state renders possible an extreme reduction of the access time and an almost unlimited conservation of the information stored in the loop $S_1$.

**2.** An information storage circuit with low access time as claimed in Claim 1, characterised in that it comprises in addition at least one transistor $T_1$ for conducting the information-carrying current towards the said second contact $C_2$ outside the loop so as to form a memory cell.

**3.** An information storage circuit with low access time as claimed in Claim 2, characterised in that it comprises in addition a grid deposited on the loop in the memory cell for generating, if so desired, a disturbance of the two-dimensional electron gas and thereby causing the superconductive characteristics of the semiconductor material to disappear instantaneously, and enabling the first transistor $T_1$ to read the information stored in the loop.

**4.** A circuit as claimed in Claim 3, characterised in that it comprises in addition a second transistor $T_2$ in the memory cell for conducting a current towards the grid GR *via* another contact $C_2$ provided against the outside of the loop and connecting the second transistor $T_2$ to the grid GR.

**5.** A circuit as claimed in Claim 4, characterised in that it comprises in addition semiconductor layers (5, 6) at the surface of the semiconductor material (3, 4) for realising the first and second contacts $C_1$ and $C_2$ in the form of ohmic contacts, and for realising the first and second transistors $T_1$ and $T_2$.

**6.** A circuit as claimed in Claim 5, characterised in that the substrate (1) is made of semi-insulating GaAs, in that the semiconductor material (3, 4) with the two-dimensional gas (G2D) is formed by stacking of one layer (3) of undoped GaAs and one layer (4) of undoped GaAlAs, in that the upper layers (5, 6) are formed by stacking of one layer (5) of AlGaAs of the n-conductivity type doped, for example, by Si, and one layer (6) of GaAs of the n-conductivity type doped, for example, by Si, in

that the transistors $T_1$ and $T_2$ are of the HEMT type, and in that the word lines in the memory cell are connected to the respective gates of the transistors $T_1$ and $T_2$, the drains of these transistors being connected to a bit line and the sources each to a contact $C_2$ outside the loop $S_1$.

7. A circuit as claimed in any one of the Claims 4 to 6, characterised in that it comprises a plurality of such memory cells arranged into a network of cells which has a matrix structure.

**Patentansprüche**

1. Datenspeicherschaltung mit kurzer Zugriffszeit, die monolithisch auf einem Substrat (1) integriert ist, dadurch gekennzeichnet, daß diese aus Halbleitermaterial besteht mit einem zweidimensionalen Elektronenträgergas (G2 D), wobei dieses Halbleitermaterial durch Stapelung von Schichten (3, 4) aus einem Material mit einer schmalen Bandlücke (3) und einem Material mit einer größeren Bandlücke (4), oder umgekehrt, gebildet ist, wobei das zweidimensionale Gas G2D sich am Übergang zwischen diesen beiden Schichten (3, 4) befindet, daß sie Mittel aufweist, mit deren Hilfe diesem Material ein Magnetfeld B zugeführt wird und das Material eine Temperatur erhält, durch die das genannte Halbleitermaterial superleitend wird, und daß sie mindestens eine in dem Halbleitermaterial gebildete Schleife $S_1$, einen ersten Kontakt $C_1$ zur Verbindung der Mitte der Schleife mit einem Bezugspotential, beispielsweise Masse, sowie einen zweiten Kontakt $C_2$ gegen und außerhalb der Schleife zum Injizieren eines Datenträgerstromes in die Schleife $S_1$ aufweist, wobei das Halbleitermaterial in dem superleitenden Zustand eine wesentliche Zugriffszeitverringerung ermöglicht sowie eine nahezu unbeschränkte Aufbewahrung der in der Schleife $S_1$ gespeicherten Daten.

2. Datenspeicherschaltung mit kurzer Zugriffszeit nach Anspruch 1, dadurch gekennzeichnet, daß die Datenspeicherschaltung zum Bilden einer Speicherzelle außerdem mindestens einen Transistor $T_1$ aufweist um den Datenträgerstrom dem genannten zweiten Kontakt $C_2$ außerhalb der Schleife zuzuführen.

3. Datenspeicherschaltung mit kurzer Zugriffszeit nach Anspruch 2, dadurch gekennzeichnet, daß diese Schaltungsanordnung außerdem in der Speicherzelle ein auf der Schleife niedergeschlagenes Gitter GR aufweist um, gewünschtenfalls, die Zerstörung des zweidimensionalen Elektronengases durchzuführen und dadurch die superleitenden Eigenschaften des Halbleitermaterials augenblicklich verschwinden zu lassen wodurch es möglich wird, mittels des ersten Transistors $T_1$ die in der Schleife gespeicherten Daten zu lesen.

4. Schaltungsanordnung nach Anspruch 3, dadurch gekennzeichnet, daß die Schaltungsanordnung außerdem in der Speicherzelle einen zweiten Transistor $T_2$ aufweist zum Zuführen eines Stromes zu dem Gitter GR über einen anderen Kontakt $C_2$ gegen und außerhalb der Schleife, der den zweiten Transistor $T_2$ mit dem Gitter GR verbindet.

5. Schaltungsanordnung nach Anspruch 4, dadurch gekennzeichnet, daß sie außerdem auf der Halbleiteroberfläche (3, 4) Halbleiterschichten (5, 6) aufweist zum Bilden von ersten und zweiten Kontakten $C_1$ und $C_2$ in Form ohmscher Kontakte und zum Bilden eines ersten und eines zweiten Transistors $T_1$ bzw. $T_2$.

6. Schaltungsanordnung nach Anspruch 5, dadurch gekennzeichnet, daß das Substrat 1 aus halbisolierendem GaAs besteht, wobei das Halbleitermaterial (3, 4) mit einem zweidimensionalen Gas G2D durch Stapelung einer nichtdotierten GaAs-Schicht (3) und einer nicht-dotierten GaAlAs-Schicht (4) gebildet wird, daß die oberen Schichten (5, 6) durch Stapelung einer n-leitenden, beispielsweise durch Si dotierten AlGaAs-Schicht (5) und einer n-leitenden, beispielsweise durch Si dotierten GaAs-Schicht (6) gebildet werden, daß die Transistoren $T_1$ und $T_2$ vom HEMT-Typ sind, daß die Wortleitungen in der Speicherzelle mit dem Gitter des Transistors $T_1$ bzw. $T_2$ verbunden sind, deren Drain-Elektroden mit einer Bitleitung und deren Source-Elektroden mit je einem Kontakt $C_2$ außerhalb der Schleife $S_1$ verbunden sind.

7. Schaltungsanordnung nach einem der Ansprüche 4 bis 7, dadurch gekennzeichnet, daß sie eine Vielzahl derartiger Speicherzellen aufweist, die in Form eines Zellennetzwerkes mit einer Matrixstruktur gegliedert sind.

FIG.1

EP 0 280 363 B1

**FIG.2**

**FIG.3**

9

FIG.4

FIG.5